# FASCICULE DE BREVET EUROPEEN

(11) **EP 2 840 059 B1**
(45) Date de publication et mention de la délivrance du brevet: **28.09.2022**
(21) Numéro de dépôt: 14181691.8
(22) Date de dépôt: 20.08.2014
(51) Int. Cl.: B81C 1/00, G04B 15/14

(54) **Procédé de fabrication d'une pièce de micro-mécanique et la pièce fabriquée à l'aide de ce procédé**
Verfahren zur Herstellung eines mikromechanischen Teils und Teil hergestellt durch dieses Verfahren
Manufacturing process for a micro-mechanical component and component manufactured with this process

(30) Priorité: 20.08.2013 CH 14112013
(43) Date de publication de la demande: 25.02.2015
(73) Titulaire: Sigatec SA, 1950 Sion (CH)
(72) Inventeur: Glassey, Marc-André, 1967 Bramois (CH); Clivaz, Johannes, 1967 Bramois (CH)
(74) Mandataire: BOVARD AG

(56) Documents cités:
- CH-A2- 699 476
- BLAISE LAURENT PATRICK GASSEND ET AL: "Design and Fabrication of DRIE-Patterned Complex Needlelike Silicon Structures", JOURNAL OF MICROELECTROMECHANICAL SYSTEMS, IEEE SERVICE CENTER, US, vol. 19, no. 3, 1 juin 2010 (2010-06-01), pages 589-598, XP011305172, ISSN: 1057-7157
- KUO-SHEN CHEN ET AL: "Effect of Process Parameters on the Surface Morphology and Mechanical Performance of Silicon Structures After Deep Reactive Ion Etching (DRIE)", JOURNAL OF MICROELECTROMECHANICAL SYSTEMS, IEEE SERVICE CENTER, US, vol. 11, no. 3, 1 juin 2002 (2002-06-01), XP011064757, ISSN: 1057-7157
- ROXHED N ET AL: "Tapered Deep Reactive Ion Etching: Method and Characterization", SOLID-STATE SENSORS, ACTUATORS AND MICROSYSTEMS CONFERENCE, 2007. TRANSDUCERS 2007. INTERNATIONAL, IEEE, PISCATAWAY, NJ, USA, 10 juin 2007 (2007-06-10), pages 493-496, XP031216075, ISBN: 978-1-4244-0841-2

## Description

### Domaine technique de l'invention

La présente invention se rapporte à un procédé de fabrication d'une pièce de micro-mécanique, notamment d'une pièce d'horlogerie mécanique, par gravure à partir d'un substrat. Plus particulièrement, la présente invention se rapporte à un procédé de fabrication d'une pièce de micro-mécanique, notamment d'une pièce d'horlogerie mécanique, qui permet d'obtenir des pièces ayant un profil des flancs latéraux prédéterminé.

### Description de l'art antérieur

En micro-mécanique, et notamment en horlogerie mécanique, on utilise aujourd'hui beaucoup de pièces fabriquées par gravure à partir d'un substrat en un matériau approprié. Parmi les différents matériaux, le silicium (monocristallin ou polycristallin) est de plus en plus utilisé. En horlogerie mécanique, on utilise la gravure de silicium pour fabriquer des roues d'échappement, des ancres, des plateaux, des spiraux, etc. En outre, le silicium peut également être utilisé pour des engrenages, (roues et planches), des cames et pratiquement pour tous les autres composants d'une montre.

Une des technologies les plus utilisées pour la fabrication de telles pièces est la gravure ionique réactive profonde (ou « DRIE » par son acronyme anglais : Deep Reactive Ion Etching). Il s'agit d'une technologie de gravure qui a été proposée par la société allemande Bosch en 1994 et qui est aujourd'hui bien connue.

Le procédé DRIE de base est un procédé de gravure par plasma qui est multiplexé dans le temps et qui consiste en deux cycles différents, à savoir un cycle de gravure et un cycle de passivation. Dans le premier cycle, on utilise des ions produits par un plasma (par exemple le gaz ionisé SF₆ pour la gravure de silicium). Par la suite, ce gaz de plasma est remplacé par un autre gaz (par exemple C₄F₈) qui résulte en la déposition d'une couche de passivation en un matériau similaire au Teflon sur toutes les surfaces du substrat, y compris les surfaces latérales. Cette couche de passivation protège donc les surfaces latérales du substrat lors du cycle de gravure suivant qui est de nouveau effectué en utilisant le gaz ionisé SF₆. Dans ce cas, une première partie de ce cycle de gravure est utilisée pour l'élimination de la couche de passivation déposée sur le fond de l'entaille qui a été réalisée dans le cycle de gravure précédent, pendant que la deuxième partie de ce cycle est utilisée pour poursuivre la gravure du substrat proprement dit.

Cette première partie du cycle de gravure (qui est souvent appelée la « dépassivation ») joue un rôle très important au niveau de performance globale du procédé de gravure par le fait qu'elle influence fortement le profil final de l'entaille, et ainsi le profil des flancs latéraux des pièces fabriquées par ce procédé.

En effet, l'intérêt principal des procédés de gravure ionique réactive profonde (DRIE) est le fait qu'il permet de réaliser des pièces ayant les flancs verticaux (ou presque verticaux). En plus, un bon choix des différents paramètres de gravure (et particulièrement du temps d'application des différentes cycles du procédé) permet d'obtenir des pièces qui ont non seulement les flancs verticaux, mais également lisses. Cependant, la verticalité n'est malheureusement pas toujours parfaite et les flancs des pièces présentent assez souvent une certaine inclinaison par rapport à la verticale qui les rend fortement moins intéressantes pour une utilisation dans les mécanismes qui requièrent une précision accrue.

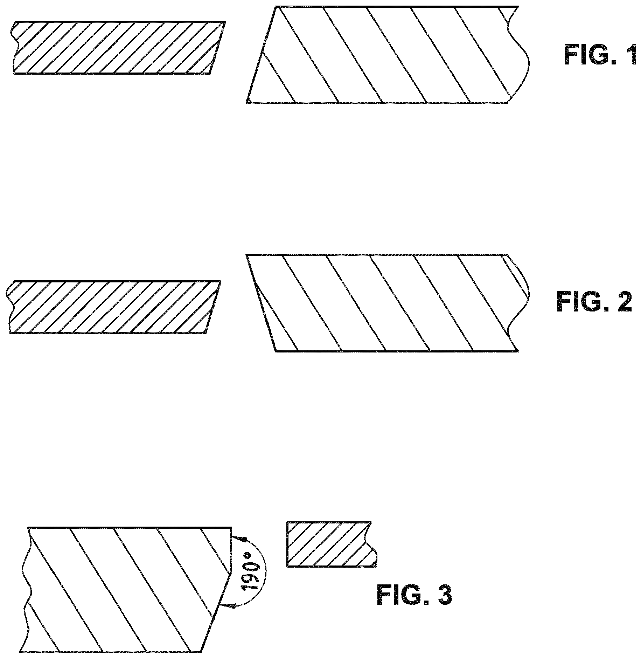

En effet, lors d'assemblage des pièces présentant des flancs non verticaux, on peut se trouver dans les deux cas suivants (illustrés schématiquement aux Figures 1 et 2) :
- 1^{er} cas (représenté à la Figure 1) avec un parallélisme des gravures. Dans ce cas, les flancs des pièces qui entrent en contact (p.ex. dans un train d'engrenages ou dans le couple ancre-roue d'échappement d'un mouvement horloger) sont inclinés « dans le même sens » par rapport à la verticale. Par conséquent, les surfaces latérales des deux pièces qui entrent en contact l'une avec l'autre sont incertaines ou non maîtrisées.
- 2^{ème} cas (représenté à la Figure 2) avec les gravures de sens opposé. Dans ce cas, les surfaces en contact des deux pièces sont très petites (en principe, le contact s'effectue uniquement sur une arrête fine). Par conséquent, les pressions exercées sur ces surfaces de contact sont très grandes. Un risque de casse ou d'usure prématurée en est une conséquence directe.

A cet endroit, il est important de noter que dans toutes les Figures, les angles ont été volontairement représentés de manière exagérée pour une meilleure compréhension. Un homme du métier peut néanmoins facilement comprendre que la présente invention fonctionne également avec les angles beaucoup plus fins.

Dans l'article de Biaise Laurent Patrick Gassend et al, publié dans la revue JOURNAL OF MICROELECTROMECHANICAL SYSTEMS, IEEE SERVICE CENTER, vol. 19, n° 3, aux pages 589 à 598, sous le titre « Design and Fabrication of DRIE-Patterned Complex Needlelike Silicon Structures », il est question de structures pointues obtenues au moyen d'une gravure comprenant au moins une étape de gravure ionique réactive profonde (DRIE).

Un procédé de fabrication selon le préambule de la revendication 1 annexée est décrit dans la demande de brevet suisse CH 699 476, où l'on trouve un exemple de fabrication d'un composant horloger dans du silicium, par gravure ionique réactive profonde (DRIE).

### Exposé sommaire de l'invention

Le but majeur de la présente invention est donc de proposer un procédé de fabrication d'une pièce de micro-mécanique, notamment d'une pièce d'horlogerie mécanique, par gravure à partir d'un substrat gravure qui ne présente pas les inconvénients susmentionnés et qui est notamment apte à produire une pièce de micro-mécanique ayant des flancs latéraux tels que le contact entre ces flancs latéraux et une autre pièce soit mieux maîtrisé.

A cet effet, ce but de la présente invention est atteint par un procédé de fabrication selon la revendication 1.

Plus concrètement, ce but de la présente invention est atteint au moyen d'un procédé de fabrication d'une pièce de micro-mécanique, notamment d'une pièce d'horlogerie mécanique, par gravure de flancs entre une face inférieure de la pièce de micro-mécanique et une face supérieure de la pièce de micro-mécanique, à partir d'un substrat, étant précisé que les flancs comprennent une surface de contact pour le transfert de couples et/ou de forces entre la pièce de micromécanique et une autre pièce. Le procédé de fabrication au moyen duquel est atteint le but de l'invention comprend au moins une première étape effectuée par gravure ionique réactive profonde (DRIE) avec les paramètres ajustés afin de réaliser une gravure produisant les flancs essentiellement verticaux ou avec les paramètres ajustés de manière continue afin de réaliser une gravure produisant les flancs avec une courbure convexe, ainsi qu'une deuxième étape effectuée par gravure ionique réactive profonde (DRIE) avec les paramètres ajustés afin de réaliser une gravure produisant les flancs inclinés sous un angle prédéterminé par rapport à la verticale ou avec les paramètres ajustés de manière continue afin de réaliser une gravure produisant des flancs avec une courbure convexe. La première et la deuxième étape sont réalisées de manière continue, sans arrêt de la gravure ionique réactive profonde.

L'avantage d'un tel procédé réside notamment dans le fait qu'il permet de réaliser les pièces de micro-mécanique, et notamment aussi les pièces d'horlogerie mécanique, ayant les flancs optimisés. De telles pièces permettent plus particulièrement un bon contrôle des surfaces de contact entre des pièces qui entrent un contact, par exemple dans un mouvement horloger. En outre, la réalisation des deux étapes de manière continue garantit une optimisation du procédé.

De manière notable, dans le cas où les paramètres dans la deuxième étape sont ajustés afin de réaliser une gravure produisant les flancs inclinés sous l'angle prédéterminé, les paramètres dans la deuxième étape du procédé peuvent être ajustés afin de produire les flancs formant un angle obtus avec la verticale. Dans la présente demande, la définition d'un angle obtus ne coïncide pas forcément avec la définition purement géométrique. En effet, un flanc formant un angle obtus avec la verticale (dans le sens de la présente invention) est représenté à la Figure 3, dans la partie de la pièce en bas de la partie avec le flanc vertical. Une autre définition de la position du flanc produit lors de la deuxième étape du procédé selon la présente invention peut aussi être donnée par rapport au plan horizontal (situé sous l'angle de 90° par rapport à la verticale), par exemple le plan de la surface supérieure et/ou de la surface inférieure de la pièce. Dans ce sens, le flanc est positionné sous un angle obtus (plus grand de 90°) par rapport à ce plan horizontal. Spécifiquement, un tel angle d'inclinaison est réalisé par l'augmentation de la largeur de l'entaille pendant la gravure.

Selon un mode de réalisation de la présente invention dans le cas où les paramètres dans la première étape sont ajustés afin de réaliser une gravure produisant les flancs essentiellement verticaux et où les paramètres dans la deuxième étape sont ajustés afin de réaliser une gravure produisant les flancs inclinés sous l'angle prédéterminé, les angles entre les deux flancs (réalisés dans les deux étapes du procédé) sont au maximum de 190°, comme représenté à la Figure 3. Ceci permet d'obtenir les surfaces de pièces de micro-mécanique ayant un profil souhaité.

Selon un autre mode de réalisation de la présente invention, les paramètres ajustés dans la première étape et/ou dans la deuxième étape du procédé sont le temps d'application du cycle de gravure et/ou le temps d'application du cycle de passivation. Plus particulièrement, le temps d'application du cycle de passivation joue un rôle primordial dans la réalisation du profil voulu. Un cycle de passivation court crée en effet une couche de passivation moins épaisse et une telle couche nécessite bien entendu également un temps de « dépassivation » moins long (et vice-versa). En ajustant ces paramètres d'une manière appropriée, on arrive à créer des flancs inclinés de manière prédéterminée.

Dans le cas où les paramètres dans la première étape sont ajustés de manière continue afin de réaliser une gravure produisant les flancs avec la courbure convexe et/ou dans le cas où les paramètres dans la deuxième étape sont ajustés de manière continue afin de réaliser une gravure produisant les flancs avec la courbure convexe, les rayons de courbure des flancs avec la courbure convexe peuvent avantageusement avoir une valeur supérieure à la moitié de la hauteur gravée. En effet, un ajustement continu des paramètres des différentes étapes du procédé gravure permet de réaliser des flancs d'une forme courbe, sans parties en forme de pointe. Une telle forme de surface permet de contrôler d'avantage les surfaces de contact d'une pièce et d'optimiser d'avantage le procédé.

De manière notable, le substrat est le silicium monocristallin et/ou le silicium polycristallin. Ces matériaux possèdent de nombreux avantages pour la fabrication des pièces de micro-mécanique. Bien entendu, d'autres matériaux ou mélanges de matériaux sont également possibles.

Aussi, dans un autre mode de réalisation avantageux de la présente invention, le gaz de plasma peut de manière avantageuse être le gaz SF₆ et/ou le gaz de passivation peut de manière avantageuse être C₄F₈. Ces gaz présentent des avantages importants pour la gravure de silicium puisqu'ils permettent de réaliser une gravure dans un substrat en silicium monocristallin ou polycristallin avec les propriétés souhaitées.

De manière très générale, le domaine d'application de la présente invention peut être élargi à d'autres substrats et d'autres procédés de gravure pour recourir aux mêmes avantages. Par exemple, les gravures directes RIE utilisées pour d'autres matériaux (céramiques et verre) pourraient être optimisées pour obtenir les mêmes avantages.

A cet endroit, il est également important de remarquer qu'un autre but de la présente invention est de proposer une pièce de micro-mécanique, notamment une pièce d'horlogerie mécanique, ayant des flancs latéraux tels que le contact entre ces flancs latéraux et une autre pièce soit mieux maîtrisé.

L'invention a également pour objet une pièce de micro-mécanique selon la revendication 8.

### Brève description des dessins

D'autres caractéristiques et avantages de l'invention vont maintenant être décrits en détail dans l'exposé suivant qui est donné en référence aux figures annexées, lesquelles représentent :
- figure 1 : une représentation schématique en coupe de deux pièces de micro-mécanique fabriquées selon des procédés de fabrication de l'état de la technique, présentant des flancs latéraux inclinés de manière parallèle ;
- figure 2 : une représentation schématique en coupe de deux pièces de micro-mécanique fabriquées selon des procédés de fabrication de l'état de la technique, présentant des flancs latéraux inclinés de manière opposée ;
- figure 3 : une représentation schématique en coupe de deux pièces de micro-mécanique dont une est fabriquée selon un mode de réalisation du procédé de fabrication selon la présente invention, notamment avec un angle de 190° entre les flancs ;
- figure 4 : une représentation schématique en coupe de deux pièces de micro-mécanique dont une est fabriquée selon un mode de réalisa-tion du procédé de fabrication selon la présente invention et dont la pièce en contact a un angle garantissant un contact « angle obtus-face » ; et
- figure 5 : une représentation schématique en coupe de deux pièces de micro-mécanique dont une est fabriquée selon un mode de réalisa-tion du procédé de fabrication dont les paramètres sont modifiés en continu et dont la pièce en contact a un angle garantissant un contact « rayon-face ».

### Exposé détaillé de l'invention

Les figures 3 à 5 illustrent de manière schématique les pièces de micro-mécanique fabriquées selon des différents modes de réalisation du procédé de fabrication selon la présente invention.

Plus concrètement, la figure 3 montre schématiquement une pièce de micro-mécanique fabriquée selon un mode de réalisation du pro-cédé de fabrication selon la présente invention (à gauche) au point d'entrer en contact avec une deuxième pièce de micro-mécanique quelconque. Par souci de simplicité, une seule surface de contact est représentée, l'autre surface (de l'autre côté) étant représentée uniquement par un flanc vertical. Bien entendu, une pièce réelle possède typiquement un profil identique aussi de l'autre côté.

La pièce fabriquée à l'aide du procédé selon ce mode de réalisation de la présente invention à la figure 3 possède les flancs latéraux constitués par deux segments à orientations différents, à savoir un premier segment avec un flanc essentiellement vertical en haut et un deuxième segment avec un flanc incliné « vers l'intérieur », créant ainsi un espace de dégagement dans la partie inférieure de la pièce. Dans cet exemple, le premier segment de la pièce sert comme surface de contact avec la deuxième pièce représentée à droite. Il est évident que cette surface de contact peut être contrôlée de manière simple et efficace pour permettre un contact optimal (et le transfert des couples et/ou des forces) entre les deux pièces. L'angle entre ces deux flancs est de 190° au maximum, tel que représenté à la Figure.

Pour réaliser une telle pièce, on applique d'abord une gravure ionique réactive profonde (DRIE) avec les paramètres standard, c'est-à-dire ceux qui permettent de réaliser des flancs verticaux. Par la suite, les paramètres sont ajustés afin de réaliser la gravure des flancs sous l'angle obtus par rapport à la verticale.

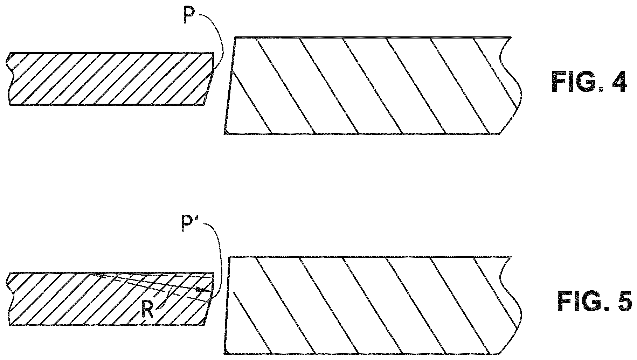

La figure 4 montre une réalisation préférée de deux pièces entrant en contact. Dans ce cas, on fait coïncider une pièce fabriquée selon le mode de réalisation du procédé expliqué ci-dessus avec une pièce ayant des flancs positionnés sous un léger angle. En ajustant les procédés de fabrication des deux pièces de manière appropriée, on obtient un contact entre les deux faces sous un angle obtus, typiquement entre 179 et 175°. Comme on peut facilement s'apercevoir, le point de contact P entre les deux pièces se trouve exactement au point de changement de pente, c'est-à-dire entre le segment incliné et le segment vertical.

En faisant évoluer les paramètres qui dictent une gravure « essentiellement verticale » à ceux ayant un angle de manière continue, on arrive à obtenir un arrondi (tel que représenté à la Figure 5). La courbure de l'arrondi (illustré schématiquement à la Figure 5) permet de régler la pression des pièces en contact et d'optimiser davantage la résistance du matériau à la cassure. Comme dans le mode de réalisation représenté à la figure 4, le point de contact P' est de nouveau situé approximativement au milieu de la pièce de gauche.

## Revendications

1. Procédé de fabrication d'une pièce de micro-mécanique, notamment d'une pièce d'horlogerie mécanique, par gravure de flancs entre une face inférieure de la pièce de micro-mécanique et une face supérieure de la pièce de micro-mécanique, à partir d'un substrat, les flancs comprenant une surface de contact pour le transfert de couples et/ou de forces entre la pièce de micromécanique et une autre pièce, le procédé de fabrication comprenant au moins
une première étape effectuée par gravure ionique réactive profonde (DRIE) avec les paramètres ajustés afin de réaliser une gravure produisant les flancs essentiellement verticaux ou avec les paramètres ajustés de manière continue afin de réaliser une gravure produisant les flancs avec une courbure convexe,
et au moins une deuxième étape effectuée par gravure ionique réactive profonde (DRIE) avec les paramètres ajustés afin de réaliser une gravure produisant les flancs inclinés sous un angle prédéterminé par rapport à la verticale ou avec les paramètres ajustés de manière continue afin de réaliser une gravure produisant des flancs avec une courbure convexe,
et la première et la deuxième étape sont réalisées de manière continue, sans interruption de la gravure ionique réactive profonde.

2. Procédé de fabrication selon la revendication 1, **caractérisé en ce que**, dans le cas où les paramètres dans la deuxième étape sont ajustés afin de réaliser une gravure produisant les flancs inclinés sous l'angle prédéterminé, les paramètres dans la deuxième étape du procédé sont ajustés afin de produire les flancs formant un angle obtus avec la verticale.

3. Procédé de fabrication selon l'une des revendications 1 ou 2, **caractérisé en ce que**, dans le cas où les paramètres dans la première étape sont ajustés afin de réaliser une gravure produisant les flancs essentiellement verticaux et où les paramètres dans la deuxième étape sont ajustés afin de réaliser une gravure produisant les flancs inclinés sous l'angle prédéterminé, les angles entre les deux flancs sont au maximum de 190°.

4. Procédé de fabrication selon l'une quelconque des revendications 1 à 3, **caractérisé en ce que** les paramètres ajustés dans la première étape et/ou dans la deuxième étape du procédé sont le temps d'application du cycle de gravure et/ou le temps d'application du cycle de passivation.

5. Procédé de fabrication selon l'une quelconque des revendications précédentes, **caractérisé en ce que**, dans le cas où les paramètres dans la première étape sont ajustés de manière continue afin de réaliser une gravure produisant les flancs avec la courbure convexe et/ou dans le cas où les paramètres dans la deuxième étape sont ajustés de manière continue afin de réaliser une gravure produisant les flancs avec la courbure convexe, les rayons de courbure des flancs avec la courbure convexe ont une valeur supérieure à la moitié de la hauteur gravée.

6. Procédé de fabrication selon l'une quelconque des revendications précédentes, **caractérisé en ce que** le substrat est le silicium monocristallin et/ou le silicium polycristallin.

7. Procédé de fabrication selon l'une quelconque des revendications précédentes, **caractérisé en ce que** le gaz de plasma est le gaz SF₆ et/ou **en ce que** le gaz de passivation est C₄F₈.

8. Pièce de micro-mécanique, notamment d'horlogerie mécanique, fabriquée à l'aide d'un procédé de fabrication selon l'une quelconque des revendications 1 à 7 et comprenant une face inférieure, une face supérieure et des flancs latéraux entre la face inférieure et la face supérieure, les flancs latéraux comprenant une surface de contact pour le transfert de couples et/ou de forces entre la pièce de micromécanique et une autre pièce, un profil prédéterminé des flancs latéraux ayant au moins :
- un premier segment essentiellement vertical obtenu par gravure ionique réactive profonde (DRIE) de manière que les flancs latéraux au niveau de ce segment essentiellement vertical soient essentiellement verticaux, ou un premier segment avec une courbure convexe obtenu par gravure ionique réactive profonde (DRIE) de manière que les flancs latéraux au niveau de ce premier segment soient avec une courbure convexe, et
- un deuxième segment incliné obtenu par gravure ionique réactive profonde (DRIE) de manière que les flancs latéraux au niveau de ce segment incliné soient inclinés sous un angle prédéterminé par rapport à la verticale et soient continus avec les flancs latéraux au niveau du premier segment, ou un deuxième segment avec une courbure convexe obtenu par gravure ionique réactive profonde (DRIE) de manière que les flancs latéraux au niveau de ce deuxième segment soient avec une courbure convexe et soient continus avec les flancs latéraux au niveau du premier segment.

## Patentansprüche

1. Verfahren zur Herstellung eines mikromechanischen Teils, insbesondere eines Teils einer mechanischen Uhr, durch Ätzen von Flanken zwischen einer unteren Fläche des mikromechanischen Teils und einer oberen Fläche des mikromechanischen Teils, ausgehend von einem Substrat, wobei die Flanken eine Kontaktfläche für die Übertragung von Drehmoment und/oder von Kräften zwischen dem mikromechanischen Teil und einem anderen Teil umfassen, das Verfahren zur Herstellung umfasst mindestens
einen ersten Schritt, der durch tiefes reaktives lonenätzen (DRIE) mit den Parametern durchgeführt wird, die angepasst werden, um ein Ätzen zu erreichen, welches im Wesentlichen vertikale Flanken erzeugt oder mit den Parametern, die angepasst werden, um ein Ätzen zu erreichen, welches Flanken mit einer konvexen Krümmung erzeugt,
und mindestens einen zweiten Schritt, der durch tiefes reaktives lonenätzen (DRIE) mit den Parametern durchgeführt wird, die angepasst werden, um ein Ätzen zu erreichen, welches Flanken erzeugt, die unter einem vorbestimmten Winkel in Bezug auf die Vertikale geneigt sind oder mit Parametern, welche in kontinuierlicher Weise angepasst sind, um ein Ätzen zu erreichen, welches Flanken mit einer konvexen Krümmung erzeugt,
und der erste und der zweite Schritt kontinuierlich durchgeführt werdern, ohne das tiefe reaktive lonenätzen zu unterbrechen.

2. Verfahren zur Herstellung nach Anspruch 1, **dadurch gekennzeichnet, dass** in dem Fall, in dem die Parameter in dem zweiten Schritt angepasst sind, um ein Ätzen durchzuführen, welches in dem vorbestimmten Winkel geneigte Flanken erzeugt, die Parameter in dem zweiten Schritt des Verfahrens angepasst werden, um die Flanken zu erzeugen, welche mit der Vertikalen einen stumpfen Winkel bilden.

3. Verfahren zur Herstellung nach einem der Ansprüche 1 oder 2, **dadurch gekennzeichnet, dass** in dem Fall, in dem die Parameter in dem ersten Schritt angepasst werden, um ein Ätzen zu erreichen, welches die im Wesentlichen vertikalen Flanken erzeugt und die Parameter in dem zweiten Schritt angepasst werden, um ein Ätzen zu erreichen, welches die Flanken erzeugt, die in einem vorbestimmten Winkel geneigt sind, beträgt der Winkel zwischen den Flanken maximal 190°.

4. Verfahren zur Herstellung nach einem der Ansprüche 1 bis 3, **dadurch gekennzeichnet, dass** die angepassten Parameter in dem ersten Schritt und/oder in dem zweiten Schritt des Verfahrens die Anwendungszeit für den Ätzzyklus und/oder die Anwendungszeit für den Passivierungszyklus sind.

5. Verfahren zur Herstellung nach einem der vorhergehenden Ansprüche, **dadurch gekennzeichnet, dass** in dem Falle, in dem die Parameter in dem ersten Schritt in einer kontinuierlichen Weise angepasst werden, um ein Ätzen zu erreichen, welches Flanken mit einer konvexen Krümmung erzeugt und/oder in dem Fall, in dem die Parameter in dem zweiten Schritt in einer kontinuierlichen Weise angepasst werden, um ein Ätzen zu erreichen, welches Flanken mit konvexer Krümmung erzeugt, die Krümmungsradien der Flanken mit konvexer Krümmung einen grösseren Wert haben als die Hälfte der geätzten Höhe.

6. Verfahren zur Herstellung nach einem der vorhergehenden Ansprüche, **dadurch gekennzeichnet, dass** das Substrat ein monokristallines Silizium und/oder polykristallines Silizium ist.

7. Verfahren zur Herstellung nach einem der vorhergehenden Ansprüche, **dadurch gekennzeichnet, dass** das Plasmagas das Gas SF₆ und/oder dass das Passivierungsgas C₄F₈ ist.

8. Mikromechanisches Teil, insbesondere einer mechanischen Uhr, hergestellt mit Hilfe eines Verfahrens zur Herstellung nach einem der Ansprüche 1 bis 7 und umfassend eine untere Fläche, eine obere Fläche und laterale Flanken zwischen der unteren Fläche und der oberen Fläche, wobei die lateralen Flanken eine Kontaktfläche zur Übertragung von Drehmoment und/oder Kräften zwischen dem mikromechanischen Teil und einem anderem Teil umfassen, wobei ein vorbestimmtes Profil der lateralen Flanken mindestens aufweist:
- ein erstes im Wesentlichen vertikales Segment, das durch tiefes reaktives lonenätzen (DRIE) erhalten wird, so dass die lateralen Flanken an diesen im Wesentlichen vertikalen Segmenten im Wesentlichen vertikal sind, oder ein erstes Segment mit einer konvexen Krümmung durch tiefes reaktives lonenätzen (DRIE) erhalten wird, so dass die lateralen Flanken an dem ersten Segment eine konvexe Krümmung hat, und
- ein zweites geneigtes Segment, das durch tiefes reaktives lonenätzen (DRIE) erhalten wird, so dass die lateralen Flanken an dem geneigten Segment in einem vorbestimmten Winkel in Bezug zu der Vertikalen geneigt sind und kontinuierlich mit den lateralen Flanken des ersten Segments sind, oder ein zweites Segment mit einer konvexen Krümmung, das durch tiefes reaktives lonenätzen (DRIE) erhalten wird, so dass die lateralen Flanken an dem zweiten Segment eine konvexe Krümmung haben, und kontinuierlich mit den lateralen Flanken des ersten Segments sind.

## Claims

1. Method of manufacture of a micro-mechanical piece, in particular of a piece from mechanical watchmaking, by etching of flanks between a lower face of the micro-mechanical piece and an upper face of the micro-mechanical piece, starting from a substrate, the flanks comprising a contact surface for the transfer of torque and/or of forces between the micro-mechanical piece and another piece, the method of manufacture comprising at least
a first step by performed by deep reactive ion etching (DRIE) with the parameters adjusted in order to achieve an etching producing substantially vertical flanks or with the parameters adjusted in a continuous way in order to achieve an etching producing flanks with a convex curvature,
and at least a second step performed by deep reactive ion etching (DRIE) with the parameters adjusted in order to achieve an etching producing flanks inclined at a predetermined angle with respect to the vertical or with the parameters adjusted in a continuous way in order to achieve an etching producing flanks with a convex curvature,
and the first and the second step are achieved in a continuous way, without interruption of the deep reactive ion etching.

2. Method of manufacture according to claim 1, **characterized in that**, in case where the parameters in the second step are adjusted in order to perform an etching producing the inclined flanks at the predetermined angle, the parameters in the second step of the method are adjusted in order to produce the flanks forming an obtuse angle to the vertical.

3. Method of manufacture according to one of the claims 1 or 2, **characterized in that**, in the case where the parameters in the first step are adjusted in order to achieve an etching producing the substantially vertical flanks and where the parameters in the second step are adjusted in order to achieve an etching producing the flanks inclined at the predetermined angle, the angles between the two flanks are at most 190°.

4. Method of manufacture according to any one of the claims 1 to 3, **characterized in that** the adjusted parameters in the first step and/or in the second step of the method are the application time of the etching cycle and/or the application time of the passivation cycle.

5. Method of manufacture according to any one of the preceding claims, **characterized in that**, in the case where the parameters in the first step are adjusted in a continuous way in order to achieve an etching producing the flanks with convex curvature and/or in the case where the parameters in the second step are adjusted in a continuous way in order to achieve an etching producing flanks with convex curvature, the radii of curvature of the flanks with convex curvature have a value greater than half the etched height.

6. Method of manufacture according to any one of the preceding claims, **characterized in that** the substrate is monocrystalline silicon and/or polycrystalline silicon.

7. Method of manufacture according to any one of the preceding claims, **characterized in that** the plasma gas is the gas SF₆ and/or **in that** the passivation gas is C4Fs.

8. Micro-mechanical piece, in particular of mechanical watchmaking, produced with the aid of a method of manufacture according to any one of the claims 1 to 7 and comprising a lower face, an upper face and lateral flanks between the lower face and the upper face, the lateral flanks comprising a contact surface for the transfer of torque and/or of forces between the micro-mechanical piece and another piece, a predetermined profile of the lateral flanks having at least:
- a first substantially vertical segment obtained by deep reactive ion etching (DRIE) in such a way that the lateral flanks at this substantially vertical segment are substantially vertical, or a first segment with a convex curvature obtained by deep reactive ion etching (DRIE) in such a way that the lateral flanks at this first segment are with a convex curvature, and
- a second inclined segment obtained by deep reactive ion etching (DRIE) in such a way that the lateral flanks at this inclined segment are inclined at a predetermined angle with respect to the vertical and are continuous with the lateral flanks at the first segment, or a second segment with a convex curvature obtained by deep reactive ion etching (DRIE) in such a way that the lateral flanks at this second segment are with a convex curvature, and are continuous with the lateral flanks at the first segment.
